(19) Europäisches Patentamt
European Patent Office
Office européen des brevets

(11) Veröffentlichungsnummer: **0 505 757 A1**

# (12) EUROPÄISCHE PATENTANMELDUNG

(21) Anmeldenummer: **92103335.3**

(22) Anmeldetag: **27.02.92**

(51) Int. Cl.[5]: **G03F 7/039**, G03F 7/20

(30) Priorität: **09.03.91 DE 4107662**

(43) Veröffentlichungstag der Anmeldung: **30.09.92 Patentblatt 92/40**

(84) Benannte Vertragsstaaten: **AT BE CH DE ES FR GB IT LI NL SE**

(71) Anmelder: **BASF Aktiengesellschaft**
**Carl-Bosch-Strasse 38**
**W-6700 Ludwigshafen(DE)**

(72) Erfinder: **Hoessel, Peter, Dr.**
**Salierstrasse 71**
**W-6707 Schifferstadt(DE)**
Erfinder: **Hoffmann, Gerhard, Dr.**
**Pappelstrasse 22**
**W-6701 Otterstadt(DE)**
Erfinder: **Wuensch, Thomas, Dr.**
**Dr.-Dahlem-Strasse 8**
**W-6702 Bad Duerkheim(DE)**
Erfinder: **Langen, Juergen, Dr.**
**Am Herrengarten 65**
**W-5300 Bonn 3(DE)**

## (54) Verfahren zur Herstellung von Mikroformkörpern mit hohem Aspektverhältnis.

(57) Die Erfindung betrifft ein Verfahren zur Herstellung von Mikroformkörpern mit hohem Aspektverhältnis durch bildmäßiges Bestrahlen von Polymeren mit energiereicher paralleler Strahlung aus Röntgenstrahlquellen, wobei als Polymere Copolymere aus $SO_2$ und einer oder mehreren ethylenisch ungesättigten organischen Verbindungen eingesetzt werden.

EP 0 505 757 A1

Die Erfindung betrifft ein Verfahren zur Herstellung von Mikroformkörpern mit hohem Aspektverhältnis, d.h., mit extrem großen Strukturhöhen bei Lateralabmessungen im Mikrometerbereich, durch Bestrahlen von Polymeren oder Polymermischungen und nachfolgender Entwicklung mit geeigneten Entwicklermedien.

Die Entwicklung der Mikroelektronik hat gezeigt, daß die konsequente Miniaturisierung und Integration zu einer unüberschaubaren Vielfalt neuer Produkte mit entsprechenden Technologien führt. Die Mikroelektronik hat in wenigen Jahren gegenüber anderen Industriezweigen einen gewaltigen Vorsprung in der Miniaturisierung gewonnen. Inzwischen zeichnet sich ab, daß in Zukunft auch andere Mikrotechniken eine große Bedeutung erlangen werden, wobei insbesondere die Mikromechanik und die integrierte Optik zu erwähnen sind. Solche Techniken eröffnen in der Kombination mit der Mikroelektronik eine unvorstellbare Zahl neuer elektronischer, optischer, biologischer und mechanischer Funktionselemente.

Bei einer Massenfertigung von nichtelektronischen Bauelementen, Systemkomponenten und Subsystemen der Mikrotechnik wird man naturgemäß die außerordentlich leistungsfähigen Fertigungsmethoden der Halbleitertechnik in möglichst großem Umfang nutzen. Gleichzeitig muß man versuchen, klassische Methoden der Feinwerktechnik für die Mikromechanik zu ertüchtigen und mit entsprechend modifizierten Halbleiterfertigungsmethoden zu verschmelzen, um so die engen Grenzen der Siliciumplanartechnik verlassen und neue Gestaltungsmöglichkeiten erschließen zu können, die auf einer Vielfalt von Formen und Materialien aufbauen. Diese Forderung wird z.B. in hohem Maße durch das LIGA-Verfahren erfüllt, das auf den Fertigungsschritten

- Lithographie,
- Galvanoformung und
- Abformung

aufbaut und am Kernforschungszentrum Karlsruhe (KfK) entwickelt worden ist. Es ermöglicht die Herstellung von Mikrostrukturkörpern mit hohem Aspektverhältnis, d.h. mit Lateralabmessungen im Mikrometerbereich bei Strukturhöhen von mehreren hundert Mikrometern, aus Kunststoffen, Metallen und keramische Massen.

Das LIGA-Verfahren basiert auf dem Konzept, durch einen Lithographieprozeß mit hoher Tiefenschärfe präzise Primärstrukturen mit großer Strukturhöhe herzustellen und diese Strukturen durch einen oder mehrere Abformungsprozesse vielfach zu replizieren. Dieses Fertigungskonzept kann flexibel an die durch das jeweilige Mikrostrukturprodukt vorgegebenen Randbedingungen angepaßt werden, die sich unter anderem auf die Geometrie, die verwendeten Werkstoffe oder auch auf die Stückzahl beziehen und die Art und Abfolge der einzelnen Fertigungsschritte festlegen.

Ein typischer Fertigungsablauf für die Massenfertigung von Mikrostrukturkörpern aus Metall nach dem LIGA-Verfahren enthält mehrere Prozeßschritte.

In einem ersten Prozeßschritt wird eine bis zu mehreren hundert Mikrometern dicke Polymerschicht auf einem elektrisch leitfähigen Substrat über eine Röntgenmaske mit hochintensiver, paralleler Röntgenstrahlung bestrahlt, die als sogenannte Synchrotronstrahlung in einem Elektronensynchrotron oder einem Elektronenspeicherring erzeugt wird.

Durch die Bestrahlung wird die Löslichkeit des Polymers oder der Polymermischung in ausgewählten Entwicklermedien so stark erhöht, daß die bestrahlten Materialbereiche entfernt werden können, wodurch eine reliefartige Polymerstruktur auf dem elektrisch leitenden Substrat entsteht.

Im nächsten Fertigungsschritt wird galvanisch Metall zwischen die Polymerstrukturen auf dem Substrat abgeschieden, so daß sich eine zum Polymerrelief komplementäre Metallstruktur ergibt. Setzt man die Metallabscheidung so lange fort, bis die Polymerstrukturen mit einer dicken Metallschicht überwachsen sind, so erhält man einen stabilen, zusammenhängenden Mikrostrukturkörper aus einheitlichem Material, der im nächsten Prozeßschritt als Formeinsatz für einen Abgießprozeß mit Kunststoff verwendet werden kann. Eine Massenfertigung von Mikrostrukturkörpern aus Kunststoff ist damit möglich.

Die dabei erzeugte Kunststoffstruktur kann entweder bereits das Endprodukt darstellen, oder man kann unter Verwendung einer metallischen Angießplatte wiederum eine Schablone für einen weiteren Galvanoformungsschritt erzeugen. Solche Schablonen sind wiederum in einer Vielzahl herstellbar.

Der beschriebene Fertigungsablauf kann an die Bedürfnisse spezieller Mikrostrukturen adaptiert werden, so daß mannigfach unterschiedliche Mikrostrukturen erzeugt werden können. Interessante Mikrostrukturprodukte sind Sensoren zur Messung von Beschleunigung, Durchfluß, Ultraschall, Feuchte u.ä., Mikromotoren, mikropneumatische Bauelemente, Mikrostecker für die Mikroelektronik, mikrooptische Bauelemente, Faseroptiken, Mikroelektroden, Spinndüsen, Mikrofilter, Gleitlager, Membrane und vieles andere mehr.

Der wesentliche Fertigungsschritt des LIGA-Verfahrens ist die strukturgenaue Bestrahlung des eingesetzten Polymeren. Die prinzipielle Durchführbarkeit des LIGA-Verfahrens konnte anhand einfacher Mikrostrukturen mit einem speziell hergestellten Polymethylmethacrylat (im folgenden PMMA genannt) nachgewiesen werden.

Bei der Umsetzung komplexer dreidimensionaler Strukturen hat sich gezeigt, daß PMMA einen hohen Bestrahlungsaufwand erfordert.

Weiter hat sich gezeigt, daß bei der Entwicklung der bestrahlten Polymeranteile mit einem geeigneten Entwicklermedium die unbestrahlten Polymeranteile quellen, wobei feine Mikrostrukturen zerstört werden können. Andererseits können gequollene Polymeranteile beim Austrocknen zu Spannungsrissen führen, die bei der Galvanik zu unbrauchbaren Mikrostrukturkörpern führen. Ursache für diese Probleme ist die hohe Lösungsmittelempfindlichkeit des PMMA.

Aufgabe der Erfindung war es, ein Polymer zu finden, welches eine hohe Röntgenlichtempfindlichkeit aufweist, unter dem Einfluß von Röntgenlicht depolymerisiert, und gegebenenfalls mit speziellen Entwicklern selektiv entfernbar ist; das Polymere sollte ferner eine einfache Probekörperherstellung, beispielsweise durch Spritzguß, Pressen, Extrusion bzw. Gießen ermöglichen und keine Quellung, keine Spannungsrisse und keine Fehlstellen aufweisen.

Überraschenderweise wurde gefunden, daß Polyalkensulfone, also Copolymere aus $SO_2$ und ethylenisch ungesättigten organischen Verbindungen diese Forderungen erfüllen.

Aliphatische Polysulfone und deren Herstellung sind bereits bekannt und beispielsweise in Houben Weyl, Methoden der organischen Chemie, Band E20, Makromolekulare Stoffe, Teil 2 (1987, 4. Auflage, Georg Thieme Verlag Stuttgart), Seiten 1468 ff beschrieben.

Die Verwendung von Polyalkensulfonen als Löslichkeitsinhibitoren für Novolakmatrices wird in der US-A-4 409 317, ihre Verwendung als Röntgenlicht- und Elektronenstrahlresiste ist in US-A-4 888 392, EP-A-0 211 161, US-A-4 409 317, US-A-3 893 127, US-A-4 267 257, US-A-4 289 845 und US-A-4 398 001 beschrieben.

Die in diesen Patentschriften genannten und dafür verwendeten Schichtdicken betragen jedoch in der Regel nur einige Zehntel Mikrometer bis einige Mikrometer. Die Verwendbarkeit von Polyalkensulfonen zur Herstellung von Mikroformkörpern, bei denen es auf ein hohes Aspektverhältnis ankommt, wie dies für das LIGA-Verfahren erforderlich ist, und die sich dabei ergebenden Vorteile waren überraschend und konnten aus diesen Patentschriften nicht hergeleitet werden.

Gegenstand der vorliegenden Erfindung ist ein Verfahren zur Herstellung von Mikroformkörpern mit hohem Aspektverhältnis durch bildmäßiges Bestrahlen von Polymeren mit energiereicher paralleler Strahlung aus Röntgenstrahlquellen, das dadurch gekennzeichnet ist, daß als Polymere Copolymere aus $SO_2$ und einer oder mehreren ethylenisch ungesättigten organischen Verbindungen eingesetzt werden.

Unter Mikroformkörpern mit hohem Aspektverhältnis im Sinne der Erfindung werden Mikrostrukturkörper mit Strukturtiefen von mehreren $\mu$m bis in den mm-Bereich verstanden.

Als energiereiche parallele Strahlung wird dabei vorzugsweise Synchrotonstrahlung eingesetzt.

Das Aufbringen der Copolymeren aus $SO_2$ und einer oder mehreren ethylenisch ungesättigten organischen Verbindungen auf einen Träger kann durch Spritzguß, Extrusion, Gießen und/oder Pressen, vorzugsweise in Schichtdicken bis 2000 $\mu$m erfolgen.

Gegenstand der vorliegenden Erfindung ist auch ein Verfahren zur Herstellung von Mikrostrukturen, wobei Copolymere aus $SO_2$ und einer oder mehreren ethylenisch ungesättigten organischen Verbindungen nach bildmäßiger Bestrahlung mit Synchrotronstrahlung und nach Einwirkung selektiver Entwickler mit einer Abtragstiefe von 50 $\mu$m bis zu 2000 $\mu$m bei lateralen Abmessungen unter 10 $\mu$m strukturiert werden.

Überraschend war, daß Polyalkensulfone nach Belichtung mit Synchrotronstrahlung durch spezielle Masken und nachfolgende Entwicklungsschritte mit selektiven Entwicklermedien wie i-Propanol oder Gemische aus i-Propanol/Xylol (65:35) oder Methylethylketon/Wasser (40:60), die Herstellung von Mikrostrukturen mit lateralen Abmessungen unter 10 $\mu$m und maximalen Strukturhöhen bis zu mehreren hundert Mikrometern ermöglichen. Der Abtrag findet im Gegensatz zu PMMA zum Teil bereits während der Bestrahlung mit Synchrotronstrahlung ohne die Einwirkung spezieller Entwickler statt (Trockenentwicklung). Überraschenderweise besitzen diese Mikrostrukturteile trotz der hohen Schichtdicken keine Defekte durch eventuelle Gasentwicklung bei der Bestrahlung. Die erforderlichen Bestrahlzeiten am Synchroton sind deutlich kürzer als im Falle von PMMA. Mit einer Strahlungsdosis, welche bei PMMA nur einen Abtrag von 50 $\mu$m erlaubt, wurden Entwicklungstiefen bis 600 $\mu$m erzielt.

Als Aspektverhältnis im Sinne der Erfindung versteht man das Verhältnis von Höhe zu lateraler Dimension der Formkörperstrukturen bzw. der Reliefs oder das Verhältnis von maximaler Strukturhöhe zu minimaler lateraler Abmessung. Das Aspektverhältnis kann beim erfindungsgemäßen Verfahren in weiten Grenzen, beispielsweise zwischen 10:1 bis 1000:1, vorzugsweise zwischen 50:1 bis 100:1 variieren.

Die Bestrahlung erfolgt beim erfindungsgemäßen Verfahren mittels energiereicher paralleler Strahlung aus Röntgenstrahlquellen. Die Wellenlängen dieser Strahlen liegen in einem Bereich von 0,05 bis 10, vorzugsweise 0,1 bis 1 nm, insbesondere 0,1 bis 0,4 nm.

Derartige Bestrahlungen können beispielsweise an einem Synchrotron mit speziellen Vorabsorbern, z.B.

aus Beryllium und/oder Polyimidfolie (z.B. Kapton® der Fa. Du Pont de Nemours) mit einem Bestrahlungsaufwand von 200 bis 2000 mA min. durchgeführt werden.

Der Bestrahlungsaufwand ist abhängig von der Elektronenenergie im Elektronenspeicherring, der vom Synchrotron abgezweigt ist. Im allgemeinen beträgt die Elektronenenergie 1,6 bis 2,3 Gev.

Zur bildmäßigen Bestrahlung werden üblicherweise spezielle Röntgenmasken, beispielsweise aus einer Titanträgerfolie mit Goldabsorberstrukturen verwendet.

Als Polymere werden erfindungsgemäß Copolymere aus $SO_2$ und einer oder mehreren ethylenisch ungesättigten organischen Verbindungen eingesetzt.

Derartige Copolymere, die auch als Polyalkensulfone bezeichnet werden, und deren Herstellung sind, wie bereits oben erwähnt, bekannt und können beispielsweise durch die allgemeine Formel

$[SO_2]_m$-$[M]_n$

beschrieben werden, worin M für gleiche oder verschiedene Monomereneinheiten ethylenisch ungesättigter organischer Verbindungen als einpolymerisierter Bestandteil des Copolymeren bedeuten, m und n für Laufzahlen stehen, wobei $m+n = 50$ bis 10 000 und $m = 5$ bis 50 % von $m+n$, d.h. daß das Copolymer 5 bis 50 mol-% $SO_2$ enthalten kann.

M kann für gleiche oder verschiedene Monomereinheiten der allgemeinen Formel

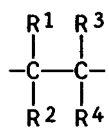

stehen, worin
$R^1$, $R^2$, $R^3$ und $R^4$ untereinander gleich oder verschieden sein können und für H, Alkyl mit 1 bis 10 Kohlenstoffatomen, Isoalkyl mit 3 bis 10 Kohlenstoffatomen stehen oder $R^2$ mit $R^4$ miteinander zu einem 5- bis 7-gliedrigen Ring verbunden sind,
M kann ebenso für gleiche oder verschiedene Monomereneinheiten der allgemeinen Formel

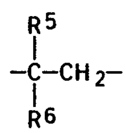

stehen, worin
$R^5$ für Phenyl oder $C_1$-$C_4$-alkylsubstituiertes Phenyl und
$R^6$ für H oder $CH_3$ stehen;
oder M kann für gleiche oder verschiedene Monomereinheiten der allgemeinen Formel

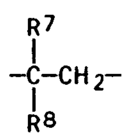

stehen, worin
$R^7$ für H oder $CH_3$ und
$R^8$ für

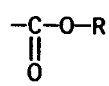

mit R = Alkyl mit 1 bis 10 Kohlenstoffatomen oder Cycloalkyl mit 5 bis 7 Kohlenstoffatomen stehen.

Beispiele für mit $SO_2$ copolymerisierbare ethylenisch ungesättigte Verbindungen sind Olefine, wie

Ethylen, Propylen, 1-Hexen, 2-Methyl-1-penten, cyclische Olefine, wie Cyclopenten, Cyclohexen, Norbornen, Diene, wie Butadien, Isopren, Hexadien, Vinylaromaten, wie Styrol, Methylstyrol, α-Methylstyrol, Vinylverbindungen, wie Acrylsäurederivate (z.B. Acrylsäureester, Acrylnitril), Acrolein, Vinylchlorid und Vinylester von Monocarbonsäuren, wie z.B. Vinylacetat.

Es können sowohl Copolymere aus $SO_2$ und einer ethylenisch ungesättigten organischen Verbindung der oben genannten Art als auch Copolymere aus $SO_2$ und einem Gemisch aus zwei, drei oder mehreren ethylenisch ungesättigten organischen Verbindung eingesetzt werden, wobei das Mengenverhältnis der ethylenisch ungesättigten organischen Verbindungen untereinander in weiten Grenzen beispielsweise im Verhältnis 1:100 bis 100:1 eingestellt werden kann.

Bevorzugt sind Copolymere aus $SO_2$ und einem oder mehreren Olefinen, wie Propen, 1-Hexen, 2-Methyl-1-penten und/oder Styrol, die 5 bis 50 mol-% $SO_2$ einpolymerisiert enthalten.

Besonders bevorzugt sind Copolymerisate und Terpolymere mit $m+n$ = 100 bis 1000 und $m$ = 45 bis 50 % für

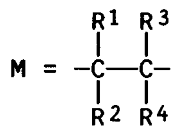

mit $R^1$ und $R^3$ = H und $R^2$ und $R^4$ = Alkyl mit 1 bis 5 Kohlenstoffatomen sowie Copolymerisate mit $m+n$ = 100 bis 1000 und $m$ = 10 bis 50 % für

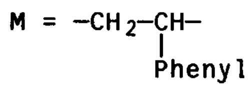

Ganz besonders bevorzugt sind die Copolymerisate

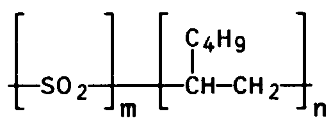

Poly-1-hexensulfon

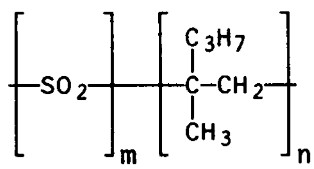

Poly-2-methyl-1-pentensulfon

mit $m$ = 45 bis 50 %,

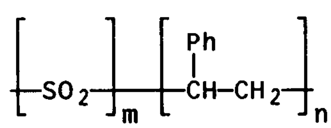

Polystyrolsulfon

mit $m$ = 5 bis 20 %
und die Terpolymeren

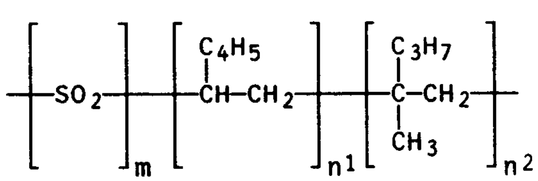

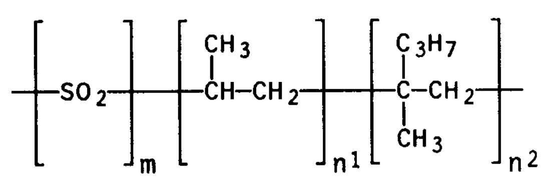

mit m = 45 bis 50 % und $n^1$ = 5 bis 50 % und $n^2$ = 5 bis 45 %.

Zur Herstellung von Formkörpern können die Copolymeren aus $SO_2$ und ethylenisch ungesättigten organischen Verbindungen als Granulat oder in Pulverform nach üblichen Verfahren, wie z.B. durch Pressen, Spritzguß und/oder Extrusion bei Temperaturen zwischen 20 und 180 °C oder durch Gießen von Lösungen der Copolymeren auf Metallträger, wie z.B. Stahl, Kupfer oder Aluminium, gegebenenfalls unter Mitverwendung spezieller Haftlacke oder spezieller Haftvermittler aufgebracht und fixiert werden. Die Schichtdicke des Copolymeren auf dem Metallträger liegt im allgemeinen zwischen 20 und 2000, vorzugsweise 50 bis 1000, insbesondere zwischen 100 und 500 µm. Die Oberfläche der Copolymerschicht sollte zweckmäßigerweise möglichst glatt sein.

Nach dem bildmäßigen Bestrahlen wird mit geeigneten Entwicklermedien, d.h. geeigneten organischen Lösungsmitteln, wie Isopropanol, oder Gemischen organischer Lösungsmittel, wie i-Propanol/Xylol (z.B. 65:35) oder Methylethylketon/Wasser (z.B. 40:60) oder Entwicklern, wie sie beispielsweise in EP-A-02 11 161 und US-A 3 893 127 beschrieben werden, entwickelt. Es werden so Abträge bis 600 µm erzielt. Die so erhaltenen Mikrostrukturen zeigen scharfe, steile Kanten und sind beständig gegenüber Galvanikbädern, d.h. z.B. Kupfer- bzw. Nickelgalvanikbädern. Bei Temperaturen zwischen 20 und 60 °C bleiben die Mikrostrukturen über 24 Stunden in den Galvanikbädern unverändert.

Die in den Beispielen genannten Teile und Prozente sind, soweit nicht anders angegeben, Gewichtsteile bzw. Gewichtsprozente.

## Beispiele

### Beispiel 1

Ein Copolymerisat ($\overline{M}_w$: 500 000), bestehend aus $SO_2$- (50 mol-%) und 2-Methyl-1-penten-Einheiten (50 mol-%), wurde durch Pressen bei 100 °C auf eine Metallplatte aufgebracht. Die Schichtdicke betrug 600 µm.

Die Bestrahlung wurde an einem Synchrotron mit üblichen Röntgenmasken und einem Bestrahlungsaufwand von 1600 mA•min durchgeführt. Der Abtrag des Polymers findet bereits während der Bestrahlung statt. Reste von Abbauprodukten in den bestrahlten Bereichen konnten mit i-Propanol bei 23 °C entfernt werden. Das Polymer war vollständig bis auf den Träger entfernt (Abtrag 600 Mikrometer). Die Mikrostrukturen zeigten die geforderte Präzision, Formstabilität und Kantensteilheit.

### Beispiel 2

Ein Terpolymer, bestehend aus $SO_2$ (50 mol-%), 1-Hexen (25 mol-%) und 2-Methyl-1-penten (25 mol-%), wurde durch Pressen bei 120 °C auf einen Metallträger aufgebracht. Die Schichtdicke betrug 600 µm.

Die Bestrahlung wurde an einem Synchrotron mit üblichen Röntgenmasken und einem Bestrahlungsaufwand von 1600 mA•min durchgeführt. Nach 10 min Entwicklung bei 23 °C mit einem Gemisch aus 65 Vol% i-Propanol und 35 Vol.-% Xylol wurde ein Abtrag von 520 Mikrometern erzielt. Die Mikrostrukturen zeigten die geforderte Präzision, Formstabilität und Kantensteilheit.

### Beispiel 3

Ein Copolymerisat ($\overline{M}_w$: 500 000), bestehend aus $SO_2$ (10 mol-%) und Styrol (90 mol-%), wurde durch Spritzguß bei 220 °C auf einen Metallträger aufgebracht. Die Schichtdicke betrug 600 µm.

Die Bestrahlung wurde an einem Synchrotron mit üblichen Röntgenmasken und einem Bestrahlungsaufwand von 1600 mA•min durchgeführt. Nach 10 min Entwicklung bei 23 °C mit einem Gemisch aus 40 Vol% Methylethylketon und 60 Vol.-% Xylol wurde ein Abtrag von 200 Mikrometern erzielt. Die Mikrostrukturen zeigten die geforderte Präzision, Formstabilität und Kantensteilheit.

### Vergleichsbeispiel

Die erfindungsgemäßen Copolymeren wurden durch Polymethylmethacrylat ersetzt und wie in Beispiel 1 beschrieben bildmäßig bestrahlt.

Bei einem Bestrahlungsaufwand von 1600 mA.min und Entwicklung mit einem Entwickler aus 60 Vol.-% Butyldiglycol, 20 Vol.-% Morpholin, 15 Vol.-% Wasser und 5 Vol.-% 2-Aminoethanol 10 min/35 °C erhält man einen Abtrag von nur 50 µm.

**Patentansprüche**

1. Verfahren zur Herstellung von Mikroformkörpern mit hohem Aspektverhältnis durch bildmäßiges Bestrahlen von Polymeren mit energiereicher paralleler Strahlung aus Röntgenstrahlquellen, dadurch gekennzeichnet, daß als Polymere Copolymere aus $SO_2$ und einer oder mehreren ethylenisch ungesättigten organischen Verbindungen eingesetzt werden.

2. Verfahren nach Anspruch 1, dadurch gekennzeichnet, daß als energiereiche parallele Strahlung Synchrotronstrahlung eingesetzt wird.

3. Verfahren nach Anspruch 1 oder 2, dadurch gekennzeichnet, daß die Copolymeren aus $SO_2$ und einer oder mehreren ethylenisch ungesättigten organischen Verbindungen durch Spritzguß, Extrusion, Gießen und/oder Pressen in Schichtdicken bis 2000 $\mu$m auf einen Träger aufgebracht werden.

4. Verfahren zur Herstellung von Mikrostrukturen, dadurch gekennzeichnet, daß die Copolymeren aus $SO_2$ und einer oder mehreren ethylenisch ungesättigten organischen Verbindungen nach Bestrahlung mit Synchrotronstrahlung und nach Einwirkung selektiver Entwickler mit einer Abtragstiefe von 50 $\mu$m bis zu 2000 $\mu$m bei lateralen Abmessungen unter 10 $\mu$m strukturiert werden.

Europäisches Patentamt

# EUROPÄISCHER RECHERCHENBERICHT

Nummer der Anmeldung

EP 92 10 3335

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| Y | FR-A-2 027 575 (E.I DU PONT DE NEMOURS AND COMPANY) * Seite 7, Zeile 10 - Zeile 32; Ansprüche 1,6; Tabellen * | 1-4 | G03F7/039 G03F7/20 |
| Y | REVIEW OF SCIENTIFIC INSTRUMENTS. Bd. 60, Nr. 7/2B, Juli 1989, EW YORK US Seiten 2160 - 2163; MOCHIJI KOZO ET AL: 'Soft X-ray spectroscopy of polymer resist using synchrotron radiation' * das ganze Dokument * | 1-4 | |
| A | MICROELECTRONIC ENGINEERING. Bd. 4, Nr. 1, Mai 1986, AMSTERDAM NL Seiten 35 - 56; BECKER E.W. ET AL: 'Fabrication of microstructures with high aspect ratios and great structural heights by synchrotron radiation lithography, galvanoforming, and plastic moulding (LIGA process)' * Seite 41, Absatz 3 - Seite 42, Absatz 2 * | 1-4 | |
| | ----- | | RECHERCHIERTE SACHGEBIETE (Int. Cl.5 ) |
| | | | G03F G03C B41C |

Der vorliegende Recherchenbericht wurde für alle Patentansprüche erstellt

| Recherchenort | Abschlußdatum der Recherche | Prüfer |
|---|---|---|
| DEN HAAG | 02 JULI 1992 | LUDI M.M.B. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)